# DEMANDE DE BREVET EUROPEEN

(11) **EP 1 837 667 A2**
(43) Date de publication de la demande: **26.09.2007**
(21) Numéro de dépôt: 07104384.8
(22) Date de dépôt: 19.03.2007
(51) Int. Cl.: G01R 31/00

(54) **Procédé de mesure des émissions parasites et des harmoniques d'un terminal de téléphonie mobile, système de mesure associé**

(30) Priorité: 20.03.2006 FR 0602401
(71) Demandeur: SAGEM Communication, 75015 Paris (FR)
(72) Inventeur: Pannétrat, Stéphane, 75015, PARIS (FR)
(74) Mandataire: Callon de Lamarck, Jean-Robert

(57) **Abrégé**

L'invention concerne un procédé de mesure des émissions parasites et des harmoniques d'un terminal de téléphonie mobile (1), caractérisé en ce qu'il comporte :
- une étape de détermination selon laquelle un analyseur de spectre (3) détermine les fréquences pour lesquelles les amplitudes radio des émissions parasites et/ou les harmoniques d'un signal émis par le terminal (1) sont supérieures à un seuil ; et
- une étape de mesure selon laquelle des moyens de mesure (3') mesurent les diagrammes de rayonnement en trois dimensions des émissions parasites et/ou des harmoniques pour les fréquences déterminées.

L'invention concerne également un système de mise en oeuvre du procédé.

## Description

### DOMAINE TECHNIQUE GENERAL

L'invention concerne un procédé de mesure des émissions parasites et des harmoniques d'un terminal de téléphonie mobile.

Elle concerne également un système de mise en oeuvre du procédé.

### ETAT DE L'ART

Les laboratoires officiels de certification des terminaux de téléphonie mobile ont développé des procédés de mesures des émissions parasites et des harmoniques, notamment en chambre anéchoïde.

Cependant, au sein des normes des télécommunications, un réel manque se fait sentir au niveau des procédés précités. Des informations concernant le paramétrage des appareils de mesures y sont mentionnées, mais elles sont insuffisantes pour une caractérisation réaliste, complète et cohérente des mesures des émissions parasites et des harmoniques. Tout au plus permettent-elles de mesurer une valeur maximale des émissions parasites et des harmoniques dans quelques directions.

### PRESENTATION DE L'INVENTION

L'invention propose de pallier au moins un de ces inconvénients.

A cet effet, l'invention propose un procédé de mesure des émissions parasites et des harmoniques d'un terminal de téléphonie mobile, caractérisé en ce qu'il comporte :
- une étape de détermination selon laquelle un analyseur de spectre détermine les fréquences pour lesquelles les amplitudes radio des émissions parasites et/ou les harmoniques d'un signal émis par le terminal sont supérieures à un seuil; et
- une étape de mesure selon laquelle des moyens de mesure mesurent les diagrammes de rayonnement en trois dimensions des émissions parasites et/ou des harmoniques pour les fréquences déterminées.

L'invention est avantageusement complétée par les caractéristiques suivantes, prises seules ou en une quelconque de leur combinaison techniquement possible :
- les moyens de mesure déterminent la puissance totale rayonnée des émissions parasites et/ou des harmoniques par intégration volumique des diagrammes de rayonnement ;
- l'analyseur effectue un balayage fréquentiel, en trois dimensions et selon deux polarisations, du signal émis par le terminal ;
- le balayage fréquentiel s'effectue dans des gammes de fréquences plus larges que les bandes de fréquences allouées pour l'utilisation du terminal, et selon les fréquences définies dans les normes en vigueur ;
- pour l'étape de détermination, le terminal est placé dans une chambre anéchoïde;
- pour l'étape de détermination, le terminal est placé dans une chambre réverbérante ;
- le terminal de téléphonie mobile est placé sur un positionneur deux axes permettant une orientation du terminal en trois dimensions pour l'étape de détermination ;
- la chambre anéchoïde est en forme d'arche permettant une détermination en trois dimensions ;
- pour l'étape de mesure, le terminal est placé dans une chambre anéchoïde ;
- le terminal de téléphonie mobile est placé sur un positionneur deux axes permettant une orientation du terminal en trois dimensions pour l'étape de mesure ;
- la chambre anéchoïde est en forme d'arche permettant une mesure en trois dimensions ;
- un simulateur de réseau relié à une antenne de communication placée dans la chambre anéchoïde ;
- l'analyseur de spectre et les moyens de mesure sont reliés à une antenne de mesure placée dans la chambre anéchoïde ;
- on choisit la forme et le matériau du positionneur, ainsi que les positions dudit positionneur, des antennes de mesure et de communication et de connectiques des antennes par rapport à la chambre pour éviter les perturbations du signal émis ;
- l'antenne de communication est placée sur le positionneur, ledit positionneur et l'antenne de mesure étant placés à une distance correspondant à deux longueurs d'onde de signal émis des parois de la chambre, et séparés entre eux par une distance minimale correspondant à six longueurs d'onde ;
- le positionneur est en matériau neutre pour les radiofréquences ;
- les étapes de détermination et de mesure sont effectuées pour une pluralité de fréquences nominales de communication du terminal d'une bande de communication; et
- les étapes sont effectuées à la première fréquence de la bande de communication, à la fréquence centrale, et à la dernière fréquence.

L'invention concerne également un système de mise en oeuvre du procédé.

L'invention présente de nombreux avantages.

L'invention permet une caractérisation réaliste, complète et cohérente des mesures des émissions parasites et des harmoniques d'un terminal de téléphonie mobile.

Elle permet notamment une caractérisation en trois dimensions des diagrammes de rayonnement des émissions parasites et des harmoniques, et pas seulement la détermination d'une valeur maximale dans une direction donnée.

### PRESENTATION DES FIGURES

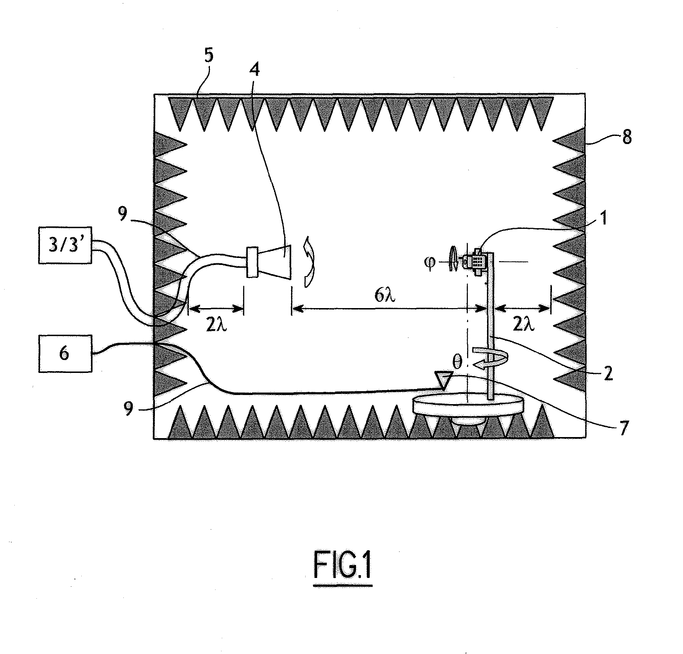

D'autres caractéristiques, buts et avantages de l'invention ressortiront de la description qui suit, qui est purement illustrative et non limitative, et qui doit être lue en regard du dessin annexé sur lequel la figure 1 unique représente un exemple d'un système de mise en oeuvre d'un procédé selon l'invention.

### DESCRIPTION DETAILLEE

La figure 1 représente schématiquement un exemple d'un système de mesure des émissions parasites et des harmoniques d'un terminal de téléphonie mobile 1.

Le système comporte un analyseur de spectre 3 pour déterminer les fréquences pour lesquelles l'amplitude radio des émissions parasites et/ou des harmoniques d'un signal émis par le terminal 1 est supérieure à un seuil. Il s'agit d'un seuil jugé critique, comme par exemple 6 dB.

Le signal émis par le terminal 1 l'est sur une fréquence nominale de communication appartenant à une bande de communication donnée, par exemple la bande de communication GSM, UMTS, DCS, etc.

Pour une fréquence nominale de communication, il peut y avoir plusieurs fréquences pour lesquelles l'amplitude radio des émissions parasites et/ou des harmoniques est supérieure au seuil, et c'est généralement le cas. Pour déterminer lesdites fréquence, l'analyseur 3 est relié à une antenne 4 de mesure effectue un balayage fréquentiel, en trois dimensions et selon deux polarisations, du signal émis par le terminal 1 et reçu par l'antenne 4 de mesure.

Le balayage fréquentiel s'effectue dans des gammes de fréquences plus larges que les bandes de fréquences allouées pour l'utilisation du terminal 1, et selon les fréquences définies dans les normes en vigueurtrès préférentiellement la norme 3GPP ou 3GPP2 (« Third Generation Protocol Project ») selon la terminologie anglo-saxonne généralement utilisée par l'homme du métier. L'analyseur 3 de spectre est commandé en fréquence, en largeur vidéo de bande fréquentielle et/ou en résolution de largeur de bande fréquentielle.

Pour effectuer la détermination en 3D, le terminal de téléphonie mobile 1 est préférentiellement placé sur un positionneur 2 deux axes permettant une orientation du terminal en trois dimensions. Les deux valeurs de rotation sur les axes de rotation sont notées respectivement θ et ϕ sur la figure 1.

La synchronisation du parcours en trois dimensions du terminal avec le balayage fréquentiel de l'analyseur 3 est optimisée selon un compromis temps/précision de mesures. Le résultat permet de mettre en évidence les pics fréquentiels correspondant aux amplitudes des émissions parasites et/ou aux harmoniques dépassant le seuil.

Pour effectuer l'étape de détermination des fréquences, le terminal 1 et l'antenne 4 peuvent être placés dans une chambre réverbérante.

Le terminal 1 et l'antenne 4 de mesure sont cependant placés préférentiellement dans une chambre anéchoïde 5, comme le montre la figure 1. On aura préalablement caractérisé complètement les atténuations de la chambre 5.

Bien entendu, pour permettre des émissions parasites et/ou des harmoniques de la part du terminal, le système comporte un simulateur 6 de réseau relié à une antenne 7 de communication placée dans la chambre anéchoïde 5. Ainsi, une communication entre le simulateur 6 de réseau et le terminal 1 peut être mise en oeuvre via l'antenne 7 de communication. Le simulateur 6 permet de paramétrer la communication établie avec le terminal 1. Dans le cas de la détermination, le terminal 1 émet à une puissance maximale.

Le système comporte en outre des moyens de mesure 3' pour mesurer un diagramme de rayonnement des émissions parasites et/ou des harmoniques pour chaque fréquence déterminée lors de l'étape de détermination. A chaque fréquence déterminée correspond ainsi un diagramme de rayonnement. Chaque diagramme de rayonnement est construit en mesurant l'amplitude radio des émissions parasites et/ou des harmoniques en fonction de la position du terminal sur le positionneur. Les diagrammes de rayonnement sont donc déterminés en 3D. De même que précédemment, le positionneur 2 deux axes permet un parcours en trois dimensions du terminal 1 pour l'étape de mesure et de construction des diagrammes de rayonnement.

Chaque diagramme de rayonnement permet, par intégration volumique, de déterminer la puissance totale rayonnée (en dBm) pour chaque fréquence déterminée, également appelée TRP (« Total Radiated Power [dBm] at F [MHz] ») selon la terminologie anglo-saxonne généralement utilisée par l'homme du métier. La TRP est bien plus réaliste vis à vis d'une utilisation réelle du terminal, où les perturbations du signal sont nombreuses. La valeur maximale de cette puissance peut être également obtenue.

Les moyens de mesure 3' sont reliés à une antenne 4 de mesure placée dans la chambre anéchoïde. Préférentiellement, les moyens de mesure 3' sont confondus avec l'analyseur de spectre 3, et partagent la même antenne 4 de mesure.

Comme on l'a vu, les étapes de détermination et de mesure s'effectuent pour une fréquence nominale de communication du terminal 1. On effectue avantageusement les étapes pour plusieurs fréquences nominales de communication. Préférentiellement, on effectue les étapes de détermination et de mesure pour trois fréquences nominales, à savoir à la première fréquence de la bande de communication, à la fréquence centrale de la bande, et à la dernière fréquence de la bande.

On choisit la forme et le matériau du positionneur 2, ainsi que les positions dudit positionneur 2, des antennes de mesure 4 et de communication 7 et de connectiques 9 des antennes 4 et 7 par rapport à la chambre, pour éviter toute perturbation du signal émis par le terminal.

Ainsi, le positionneur est préférentiellement composé de matériaux neutres pour les radiofréquences.

Préférentiellement, l'antenne 7 de communication reliée au simulateur 6 est placée sur le positionneur 2. L'antenne 7 est directive et placée à la verticale sous le terminal 1 en test. Cette configuration permet d'assurer que l'antenne 4 de mesure ne captera que ce qui est émis par le terminal 1.

Le positionneur 2 et l'antenne 4 de mesure sont placés à une distance correspondant à deux longueurs d'onde du signal émis (par exemple 1 m) des parois 8 de la chambre, et séparés entre eux par une distance minimale correspondant à six longueurs d'onde (par exemple 3 m). La chambre fait donc environ 5 m de longueur.

Les développements qui précèdent décrivent un procédé utilisant un positionneur dans une chambre anéchoïde rectangulaire, mais les mêmes opérations peuvent être effectuées en utilisant une chambre anéchoïde en forme d'arche.

## Revendications

1. Procédé de mesure des émissions parasites et des harmoniques d'un terminal de téléphonie mobile (1), **caractérisé en ce qu'**il comporte :
- une étape de détermination selon laquelle un analyseur de spectre (3) détermine les fréquences pour lesquelles les amplitudes radio des émissions parasites et/ou les harmoniques d'un signal émis par le terminal (1) sont supérieures à un seuil ; et
- une étape de mesure selon laquelle des moyens de mesure (3') mesurent les diagrammes de rayonnement en trois dimensions des émissions parasites et/ou des harmoniques pour les fréquences déterminées.

2. Procédé selon la revendication précédente, dans lequel les moyens de mesure (3') déterminent la puissance totale rayonnée des émissions parasites et/ou des harmoniques par intégration volumique des diagrammes de rayonnement.

3. Procédé selon l'une des revendications précédentes, dans lequel l'analyseur (3) effectue un balayage fréquentiel, en trois dimensions et selon deux polarisations, du signal émis par le terminal (1).

4. Procédé selon la revendication précédente, dans lequel le balayage fréquentiel s'effectue dans des gammes de fréquences plus larges que les bandes de fréquences allouées pour l'utilisation du terminal (1), et selon les fréquences définies dans les normes en vigueur.

5. Procédé selon l'une des revendications 1 à 4, dans lequel pour l'étape de détermination, le terminal (1) est placé dans une chambre anéchoïde (5).

6. Procédé selon l'une des revendications 1 à 4, dans lequel pour l'étape de détermination, le terminal (1) est placé dans une chambre réverbérante.

7. Procédé selon la revendication 5 ou 6, dans lequel le terminal de téléphonie mobile (1) est placé sur un positionneur (2) deux axes permettant une orientation du terminal en trois dimensions pour l'étape de détermination.

8. Procédé selon la revendication 5, dans lequel la chambre anécho'ide est en forme d'arche permettant une détermination en trois dimensions.

9. Procédé selon l'une des revendications précédentes, dans lequel pour l'étape de mesure, le terminal est placé dans une chambre anéchoïde (5).

10. Procédé selon la revendication 9, dans lequel le terminal de téléphonie mobile (1) est placé sur un positionneur (2) deux axes permettant une orientation du terminal en trois dimensions pour l'étape de mesure.

11. Procédé selon la revendication 9, dans lequel la chambre anéchoïde est en forme d'arche permettant une mesure en trois dimensions.

12. Procédé selon l'une des trois revendications précédentes, comportant un simulateur (6) de réseau relié à une antenne (7) de communication placée dans la chambre anéchoïde.

13. Procédé selon l'une des quatre revendications précédentes, dans lequel l'analyseur de spectre (3) et les moyens de mesure (3') sont reliés à une antenne (4) de mesure placée dans la chambre anéchoïde.

14. Procédé selon les deux revendications précédentes lorsqu'elles dépendent de la revendication 10, dans lequel on choisit la forme et le matériau du positionneur, ainsi que les positions dudit positionneur, des antennes (4, 7) de mesure et de communication et de connectiques (9) des antennes (4, 7) par rapport à la chambre pour éviter les perturbations du signal émis.

15. Procédé selon la revendication précédente, lorsqu'elle dépend de la revendication 12, dans lequel l'antenne (7) de communication est placée sur le positionneur (2), ledit positionneur et l'antenne (4) de mesure étant placés à une distance correspondant à deux longueurs d'onde de signal émis des parois (8) de la chambre, et séparés entre eux par une distance minimale correspondant à six longueurs d'onde.

16. Procédé selon l'une des deux revendications précédentes, dans lequel le positionneur est en matériau neutre pour les radiofréquences.

17. Procédé selon l'une des revendications précédentes, dans lequel les étapes de détermination et de mesure sont effectuées pour une pluralité de fréquences nominales de communication du terminal (1) d'une bande de communication.

18. Procédé selon la revendication précédente, dans lequel les étapes sont effectuées à la première fréquence de la bande de communication, à la fréquence centrale, et à la dernière fréquence.

19. Système de mesure des émissions parasites et des harmoniques d'un terminal de téléphonie mobile (1), **caractérisé en ce qu'**il comporte :
- un analyseur de spectre (3) pour déterminer les fréquences pour lesquelles les amplitudes radio des émissions parasites et/ou les harmoniques d'un signal émis par le terminal (1) sont supérieures à un seuil ; et
- des moyens de mesure (3') pour mesurer les diagrammes de rayonnement en trois dimensions des émissions parasites et/ou des harmoniques pour les fréquences déterminées et déterminer la puissance totale rayonnée des émissions parasites et/ou des harmoniques par intégration volumique des diagrammes de rayonnement.

20. Système selon la revendication 19, comportant une chambre (5) anéchoïde.

21. Système selon la revendication 20, dans lequel la chambre anéchoïde est en forme d'arche.

22. Système selon la revendication 19, comportant une chambre réverbérante.

23. Système selon l'une des revendications 19 à 21, comportant un positionneur (2) deux axes, placé dans la chambre, apte à accueillir le terminal et à orienter le terminal en trois dimensions.

24. Système selon l'une des quatre revendications précédentes, comportant un simulateur (6) de réseau relié à une antenne (7) de communication placée dans la chambre.

25. Système selon l'une des cinq revendications précédentes, dans lequel l'analyseur de spectre (3) et les moyens de mesure (3') sont reliés à une antenne (4) de mesure placée dans la chambre.

26. Procédé selon les trois revendications précédentes, dans lequel l'antenne (7) de communication est placée sur le positionneur (2), ledit positionneur et l'antenne (4) de mesure étant placés à une distance correspondant à deux longueurs d'onde de signal émis des parois (8) de la chambre, et séparés entre eux par une distance correspondant à six longueurs d'onde.

27. Procédé selon l'une des quatre revendications précédentes, dans lequel le positionneur est en matériau neutre pour les radiofréquences.
